# EUROPEAN PATENT APPLICATION

(11) **EP 1 523 019 A2**
(43) Date of publication of application: **13.04.2005**
(21) Application number: 04090374.2
(22) Date of filing: 23.09.2004
(51) Int. Cl.: H01G 9/20

(54) **Dye-sensitized solar cell with a buffer layer**

(30) Priority: 26.09.2003 KR 2003066886
(71) Applicant: Samsung SDI Co., Ltd., Suwon-si, Gyeonggi-do (KR)
(72) Inventor: Lee, Ji-Won Legal & IP Team, Samsung SDI Co.,LTD.,, Kyeonggi-Do (KR); Lee, Wha-Sup Legal & IP Team, Samsung SDI Co.,LTD., Kyeonggi-Do (KR); Choi, Jae-Man Legal & IP Team, Samsung SDI Co,LTD., Kyeonggi-Do (KR); Park, Joung-Won Legal&IP Team, Samsung SDI Co,LTD, Kyeonggi-Do (KR); Shin Byong-Cheol Legal&IP Team,Samsung SDI Co,LTD., Kyeonggi-Do (KR)
(74) Representative: Hengelhaupt, Jürgen, Dipl.-Ing.

(57) **Abstract**

It is an object of the present invention to provide a dye-sensitized solar cell which has high conversion efficiency and excellent endurance. A dye-sensitized solar cell includes a first electrode (10) and a second electrode (20) facing each other. A buffer layer (30) and a porous layer (40) are sequentially formed on the first electrode (10) and a dye (50) is adsorbed on the porous layer (40). An electrolyte (60) is impregnated between the first electrode (10) and the second electrode (20). The dye-sensitized solar cell also includes an anti-reflection film (70) formed on the outer surface of the first electrode (10).

## Description

### CROSS-REFERENCE TO RELATED APPLICATION

This application claims priority to and the benefit of Korean Application 10-2003-0066886 filed on September 26, 2003 in the Korean Intellectual Property Office, the entire content of which is incorporated herein by reference.

### FIELD OF THE INVENTION

The present invention relates to a dye-sensitized solar cell, and in particular, to a dye-sensitized solar cell which has high conversion efficiency and excellent endurance.

### BACKGROUND OF THE INVENTION

Generally, a dye-sensitized solar cell converts solar energy to electric energy using a principle similar to photosynthesis. Relatively simple processes may be used to produce dye-sensitized solar cells. Therefore, the cost of a dye-sensitized solar cell is generally lower than the cost of a SiO₂ solar cell.

A dye-sensitized solar cell using anatase TiO₂ was demonstrated by Michael Gratzel and coworkers (EPFL, Lausanne, Switzerland) in 1991. U.S. Patent No. 4,927,721 and U.S. Patent No. 5,084,365 were issued by Michael Gratzel and his coworkers. The above patents provide a regenerative photo-electrochemical cell and limit the surface roughness of the metal oxide semiconductor layer thereof.

Korean Laid-Open Patents No. 2001-0111379, 2002-0043945, 2002-0078291 and 2003-0032538 disclose dye-sensitized solar cells.

Korean Laid-Open Patent No. 10-2001-0111379 discloses a method for forming a nanocrystalline rutile titanium dioxide film and a dye-sensitized nanocrystalline titanium dioxide solar cell.

Korean Laid-Open Patent No. 10-2002-0043945 discloses a polymer electrolyte filled with TiO₂ and a manufacturing method thereof. The polymer electrolyte contains a copolymer of vinylidene fluoride, hexafluoropropylene and titania.

Korean Laid-Open Patents No. 10-2002-0078291 discloses a solar cell module and a manufacturing method thereof. In the solar cell module, the interval between solar cells is minimized when solar cells are assembled in series or parallel and the power loss is minimized.

Korean Laid-Open Patents No. 2003-0032538 discloses a dye sensitized solar battery containing titano-silicalite-2.

However, a dye-sensitized solar cell is difficult to commercialize because of low efficiency and low endurance. A dye-sensitized solar cell that is able to overcome these problems is desired.

### SUMMARY OF THE INVENTION

In accordance with embodiments of the present invention a dye-sensitized solar cell is provided that has high conversion efficiency and excellent endurance.

According to one embodiment of the present invention, a dye-sensitized solar cell includes first and second electrodes facing each other. A buffer layer and a porous layer are sequentially formed on the first electrode and a dye is adsorbed on the porous layer. An electrolyte is impregnated between the first electrode and the second electrode. The dye-sensitized solar cell further comprises an anti-reflection film formed on the outer surface of the first electrode.

The buffer layer has an energy level between the energy level of the first electrode and the energy level of the porous layer. In one embodiment, the porous layer is formed with TiO₂, and the buffer layer is formed using at least one of TiO₂, WO₃, or TiO₂-WO₃. The buffer layer may be formed using a method such as an electrolysis method, a deposition method, or a wet method. The buffer layer is denser than the porous layer.

The porous layer is formed with nanometer-sized oxide particles.

Preferred oxides for the porous layer are selected from Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, and combinations thereof.

The porous layer also includes light scattering particles formed with the same element composing the porous layer and having a diameter of 100 nm or more.

The porous layer also includes conductive particles.

The porous layer further includes high molecular compounds, which are selected from polyethylene glycol (PEG), polyethylene oxide (PEO), polyvinyl alcohol (PVA), and poly vinyl pyrrolidone (PVP), ethyl cellulose(EC), terpineol, and 2-(2-Buthoxyethoxy) ethyl acetate (BCA) and similar compounds.

The nano-sized metal oxide particles of the porous layer have a particle diameter of 100 nm or less. Preferably, the particle diameter is within a range from about 5 nm to about 40 nm. The porous layer has a surface roughness factor of 20 or more.

The dye includes a Ru complex.

The first electrode comprises a transparent substrate and a conductive film coated on the transparent substrate. The transparent substrate includes at least one of polyethylene terephthalate (PET), polyethylene naphthalate (PEN), polycarbonate (PC), polypropylene (PP), polyimide (PI), or triacetate cellulose (TAC). The conductive film includes at least one of indium tin oxide (ITO), fluorine tin oxide (FTO), ZnO-Ga₂O₃, ZnO-Al₂O₃, or SnO₂-Sb₂O₃.

The second electrode comprises a transparent substrate including one or more elements selected from the group including polyethylene terephthalate (PET), polyethylene naphthalate (PEN), polycarbonate (PC), polypropylene (PP), polyimide (PI), and triacetate cellulose (TAC). A first conductive film may coat the transparent substrate and includes one or more compounds selected from indium tin oxide (ITO), fluorine tin oxide (FTO), ZnO-Ga₂O₃, ZnO-Al₂O₃, and SnO₂-Sb₂O₃. The second conductive film includes a compound selected from the group consisting of platinum, carbon nanotube (CNT), and noble metals.

### BRIEF DESCRIPTION OF THE DRAWINGS

The above and other advantages of the present invention will become more apparent by describing embodiments thereof in detail with reference to the accompanying drawings in which:

Fig. 1 is a cross sectional view of a dye-sensitized solar cell according to an embodiment of the present invention;

Fig. 2A is a picture of the surface of a first electrode in the dye-sensitized solar cell;

Fig. 2B is a picture of the surface of a buffer layer formed on the first electrode in the dye-sensitized solar cell;

Fig. 3 is a graph that illustrates the relationship between voltage and current density for a dye-sensitized solar cell with a buffer layer and a dye-sensitized solar cell without the buffer layer;

Fig. 4 is a graph that illustrates the relationship between wave length and reflectivity for a dye-sensitized solar cell with the anti-reflection film and a dye-sensitized solar cell without the anti-reflection film; and

Fig. 5 is a graph that shows the relationship between voltage and electric current for a dye-sensitized solar cell with the anti-reflection film and a dye-sensitized solar cell without the anti-reflection film.

### DETAILED DESCRIPTION

The present invention will be described more fully hereinafter with reference to the accompanying drawings, in which embodiments of the invention are shown.

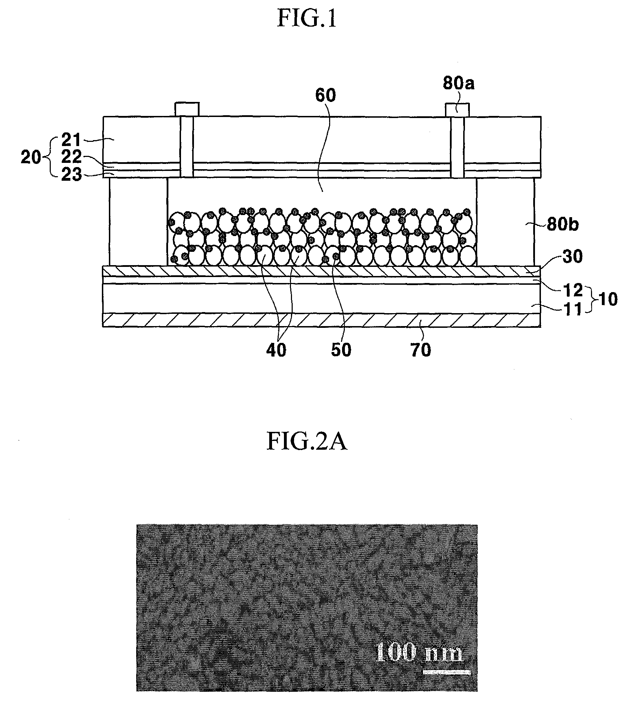

Fig. 1 is a cross sectional view of a dye-sensitized solar cell according to an embodiment of the present invention.

As shown in Fig. 1, the dye-sensitized solar cell has a first electrode (a working electrode) 10 and a second electrode (a counter electrode) 20 spaced from the first electrode by a predetermined distance. A buffer layer 30 and a porous layer 40 are sequentially formed on the inner surface of the first electrode 10 and a dye 50 is adsorbed on the porous layer 40. An electrolyte 60 is impregnated between the first electrode 10 and the second electrode 20. The dye-sensitized solar cell also includes an anti-reflection film 70 formed on the outer surface of the first electrode 10.

The first electrode 10 comprises a transparent substrate 11 and a conductive film 12 coated on the transparent substrate 11. The transparent substrate 11 includes at least one of polyethylene terephthalate (PET), polyethylene naphthalate (PEN), polycarbonate (PC), polypropylene (PP), polyimide (PI), or triacetate cellulose (TAC). The conductive film 12 includes at least one of indium tin oxide (ITO), fluorine tin oxide (FTO), ZnO-Ga₂O₃, ZnO-Al₂O₃, or SnO₂-Sb₂O₃.

The porous layer 40 is formed with nanometer-sized metal oxide particles.

The metal oxide particles are selected from Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide and combinations thereof.

The nanometer-sized metal oxide particles of the porous layer 40 generally have a uniform particle size to ensure high porosity and suitable surface roughness of the porous layer 40.

The nanometer-sized metal oxide particles of the porous layer 40 have a particle diameter of 100 nm or less. In one embodiment, the porous layer 40 is formed with TiO₂ particles with diameters ranging from about 5 nm to about 40 nm. If the size of the particles is under 5 nm, it is difficult to form a stable porous layer 40 owing to low adhesive property. If the size of the particles is over 40 nm, the conversion efficiency of the dye-sensitized solar cell decreases because the surface area of the porous layer into which the dye is adsorbed decreases. The surface roughness factor of the porous layer 40 may be optimized when the size of the particles is greater than about 20 .

To form the porous layer 40, a paste including the metal oxide is coated on the first electrode 10 and the paste is heat treated.

Methods for coating the paste on the first electrode 10 include a doctor blade method, a screen printing method and others. To form the transparent porous layer 40, a spin coating method, a spray method, or other methods may be used. In addition, a general wet method can be used. One or more properties of the applied paste may differ in accordance with the coating method utilized.

When a binder is added, the heat treatment of the paste is carried out at from about 450 to about 600 °C for 30 minutes. When a binder is not added, the heat treatment of the paste is carried out at a temperature of less than about 200 °C.

The porous layer 40 includes high molecular compounds to keep a suitable porosity. After the heat treatment, it is desirable that the high molecular compounds have not remains the organic matter. Suitable high molecular compounds include polyethylene glycol (PEG), polyethylene oxide (PEO), polyvinyl alcohol (PVA), poly vinyl pyrrolidone (PVP), ethyl cellulose(EC), terpineol, and 2-(2-Buthoxyethoxy) ethyl acetate (BCA) and similar compounds.

High molecular compounds having a suitable molecular weight may also be added. Such high molecular compounds may improve the porosity of the porous layer 40, and increase the adhesive power of the porous layer 40 due to an increase in dispersibility and viscosity.

The porous layer 40 includes conductive particles and light scattering particles. The conductive particles facilitate the movement of electrons. The light scattering particles may extend the path of light, which improves the conversion efficiency of the dye-sensitized solar cell. The light scattering particles are formed with the same element comprising the porous layer 40 and have a diameter of 100 nm or more. For instance, a light scattering particle is formed with ITO.

The dye 50 is adsorbed on the surface of the nanometer-sized particles of the porous layer 40. The dye 50 is formed from a material which absorbs visible light and includes a Ru complex. Ru belongs to the group of materials that includes platinum (the "platinum group materials" or "PGM") and Ru can make plural organometallic compounds.

Generally, a Ru(etc bpy)2(NCS)₂·2CH₃CN type dye is desirable in a dye-sensitized solar cell. The etc is a chemical reactor combining the nanometer-sized metal oxide particles of the porous layer 40 (for instance, TiO₂). Investigations are underway into new dyes that increase the efficiency of the dye-sensitized solar cell by improving the absorption of long wavelength of the visible light and facilitate electron transfer to the porous layer 40. By improving the chemical reactor, a recombination of an electron and a hole is prevented and the efficiency of the dye-sensitized solar cell improves.

Organic coloring matter may also be used as the dye of the dye-sensitized solar cell. The organic coloring matter may include coumarin, porphyrin, xanthene, riboflavin, triphenylmethane or other dyes. A single organic coloring matter can be used, or a mixture of the organic coloring matter and the Ru complex can be used. A variety of materials are available for the organic coloring matter at low cost.

The porous layer 40 is soaked in an alcohol solution with the dissolved dye for about twelve hours, and the dye 50 is adsorbed on the surface of the particles of the porous layer 40.

The buffer layer 30 is formed between the first electrode 10 and the porous layer 40. The buffer layer 30 may be formed by methods including an electrolysis method, a deposition method, or a wet method. The buffer layer 30 is denser than the porous layer 40.

The buffer layer 30 has an energy level between the energy level of the first electrode 10 and the energy level of the porous layer 40. The buffer layer 30 can be formed with the element used in the porous layer 40 or can be formed with a compound which includes the element used in the porous layer 40. For instance, where the porous layer 40 is formed with TiO₂, the buffer layer may be formed with one of TiO₂, WO₃, or TiO₂-WO₃.

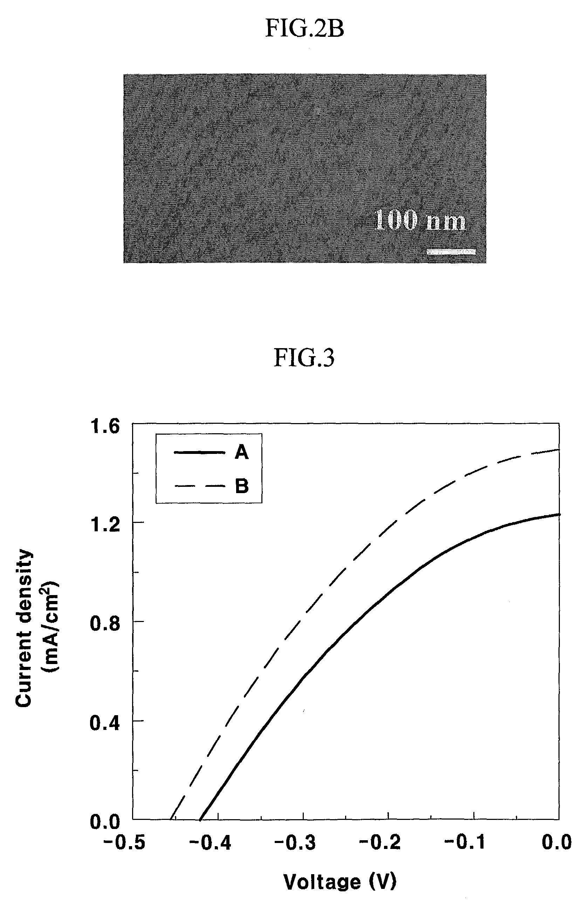

Fig. 2A is a picture of the surface of a first electrode in the dye-sensitized solar cell. Fig. 2B is a picture of the surface of a buffer layer formed on the first electrode in the dye-sensitized solar cell. The buffer layer of Figs. 2B is formed with TiO₂-WO₃.

As shown in Fig. 2A, the surface of the first electrode 10 is rough and rugged. If the porous layer is formed on the surface of the first electrode, the adhesive properties of the interface between the first electrode and the porous layer are not generally adequate. Thus, the electric property and endurance of this dye-sensitized solar cell may be inferior.

As shown in Fig. 2B, the surface of the buffer layer 30 is smooth. Because the buffer layer is denser than the porous layer, the adhesive properties improve. The detachment of the first electrode 10 is prevented because the first electrode 10 is not in contact with the electrolyte 60 due to the buffer layer 30. Thus, the electric properties, endurance and efficiency of the dye-sensitized solar cell improve.

Furthermore, the buffer layer 30 has an energy level between the energy level of the first electrode 10 and the energy level of the porous layer 40. Thus, the buffer layer 30 may balance the energy level. The recombination of an electron and a hole is prevented and the efficiency of the dye-sensitized solar cell improves.

Fig. 3 is a graph that illustrates the relationship between voltage and current density for a dye-sensitized solar cell with a buffer layer and a dye-sensitized solar cell without the buffer layer.

As shown in Fig. 3, the current density of the dye-sensitized solar cell with the buffer layer (referring to B of FIG.3) is higher than the current density of the dye-sensitized solar cell without the buffer layer (referring to A of Fig. 3). That is, the efficiency of the dye-sensitized solar cell increases as the buffer layer 30 is formed.

An anti-reflection film 70 may be formed on the outer surface of the first electrode 10. The anti-reflection film 70 decreases reflection of sunlight and reflects the sunlight into the inside of the dye-sensitized solar cell. Thus the anti-reflection film 70 may minimize the loss of the light and increase the intensity of the light.

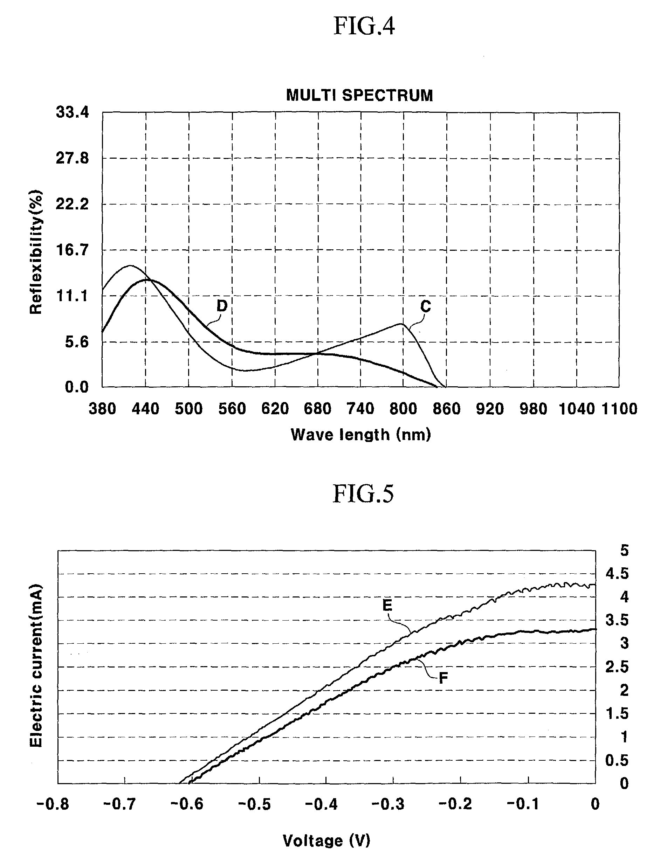

Fig. 4 illustrates the relationship between wavelength and reflectivity for a dye-sensitized solar cell with the anti-reflection film and a dye-sensitized solar cell without the anti-reflection film. Fig. 5 shows the relationship between voltage and electric current for a dye-sensitized solar cell with the anti-reflection film and a dye-sensitized solar cell without the anti-reflection film.

As shown in Fig. 4, the dye-sensitized solar cell with the anti-reflection layer (referring to C of FIG. 4) generally has a lower reflectivity than the dye-sensitized solar cell without the anti-reflection layer (referring to D of FIG. 4) in the visible region of from about 380nm to 760nm.

As shown in Fig. 5, the electric current and voltage of the dye-sensitized solar cell with the anti-reflection layer (referring to E of FIG. 5) is higher than the electric current and voltage of the dye-sensitized solar cell without the anti-reflection layer (referring to F of FIG. 5). That is, the efficiency of the dye-sensitized solar cell increases with the use of an anti-reflection layer.

As shown Fig 1, the second electrode 20 faces the first electrode 10. The second electrode 20 comprises a transparent substrate 21, a first conductive film 22 coated on the transparent substrate 21 and a second conductive film 23 coated on the first conductive film 22. The transparent substrate includes at least one of polyethylene terephthalate (PET), polyethylene naphthalate (PEN), polycarbonate (PC), polypropylene (PP), polyimide (PI), or triacetate cellulose (TAC). The conductive film includes at least one of indium tin oxide (ITO), fluorine tin oxide (FTO), ZnO-Ga₂O₃, ZnO-Al₂O₃, or SnO₂-Sb₂O_{3.} The second conductive film includes a compound selected from the group consisting of platinum, carbon nanotube (CNT), and noble metals.

The electrolyte 60 is impregnated between the buffer layer 30 and the second electrode 20. And, the electrolyte 60 is further dispersed between the nanometer-sized particles of porous layer 40. The electrolyte 60 is generally formed with an iodide-triiodide pair. The electrolyte 60 transfers electrons from the second electrode 20 to the dye 50 by oxidation and reduction. The voltage of the dye-sensitized solar cell is determined by an energy level of the dye 50 and an oxidation-reduction potential (ORP) of the electrolyte 60.

The first electrode 10 and the second electrode 20 are sealed to each other by sealant 80b. Small holes are formed penetrating the first electrode 10 and the second electrode 20. The electrolyte 60 is impregnated through the small holes. Thereafter, the small holes are sealed by sealant 80a to complete a dye-sensitized solar cell.

For the sealants 80a, 80b a polymer film, for instance Surlyn may be used. This thermoplastic polymer film is interposed between the first electrode and the second electrode and is heated and pressed such that the first electrode 10 and the second electrode 20 are sealed.

Epoxy resins and ultraviolet hardeners may also be used as sealants. In these cases, heat treatment or an ultraviolet illumination treatment may be used to seal the first electrode 10 and the second electrode 20.

Incident sunlight excites electrons within the dye 50, giving them enough energy to travel in a conduction band of the porous layer 40. The electrons transfer to the first electrode 10 through the porous layer 40 and transfer to the second electrode 20 after working at the external circuit (not shown). The electrolyte 60 carries electrons back to the dye from the second electrode by oxidation-reduction reactions. By this transfer of the electrons, the dye-sensitized solar cell works.

Although preferred embodiments of the present invention have been described in detail hereinabove, it should be clearly understood that many variations and/or modifications of the basic inventive concept herein taught which may appear to those skilled in the art will still fall within the spirit and scope of the present invention, as defined in the appended claims.

## Claims

1. A dye-sensitized solar cell comprising:
a first electrode and a second electrode facing each other;
a buffer layer formed on the first electrode;
a porous layer formed on the buffer layer;
a dye adsorbed on the porous layer; and
an electrolyte impregnated between the first electrode and the second electrode.

2. The dye-sensitized solar cell of claim 1, further comprising an anti-reflection film formed on an outer surface of the first electrode.

3. The dye-sensitized solar cell of claim 1, wherein the buffer layer has an energy level between an energy level of the first electrode and an energy level of the porous layer.

4. The dye-sensitized solar cell of claim 3, wherein the porous layer comprises TiO₂, and wherein the buffer layer comprises a compound selected from the group comprising TiO₂, WO₃, TiO₂-WO₃ and combinations thereof.

5. The dye-sensitized solar cell of claim 1, wherein the buffer layer is formed using an electrolysis method, a deposition method, or a wet method.

6. The dye-sensitized solar cell of claim 1, wherein the buffer layer is denser than the porous layer.

7. The dye-sensitized solar cell of claim 1, wherein the porous layer comprises nanometer-sized metal oxide particles.

8. The dye-sensitized solar cell of claim 1, wherein the porous layer comprises a compound selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide and combinations thereof.

9. The dye-sensitized solar cell of claim 7, wherein the porous layer further comprises light scattering particles formed with the porous layer element.

10. The dye-sensitized solar cell of claim 9, wherein the light scattering particles have a diameter of 100 nm or more.

11. The dye-sensitized solar cell of claim 7, wherein the porous layer further comprises conductive particles.

12. The dye-sensitized solar cell of claim 7, wherein the porous layer further comprises a high molecular compound selected from the group consisting of polyethylene glycol (PEG), polyethylene oxide(PEO), polyvinyl alcohol(PVA), polyvinyl pyrrolidone (PVP), ethyl cellulose(EC), terpineol, and 2-(2-Buthoxyethoxy) ethyl acetate (BCA).

13. The dye-sensitized solar cell of claim 7, wherein the nano-sized metal oxide particles of the porous layer have a diameter of 100 nm or less.

14. The dye-sensitized solar cell of claim 13, wherein the particles of the porous layer have a diameter in the range from about 5 nm to about 40 nm.

15. The dye-sensitized solar cell of claim 1, wherein the porous layer has a surface roughness factor of 20 or more.

16. The dye-sensitized solar cell of claim 1, wherein the dye comprises a Ru complex.

17. The dye-sensitized solar cell of claim 1, wherein the first electrode comprises a transparent substrate and a conductive film which is coated on the transparent substrate; the transparent substrate comprises a compound selected from the group consisting of polyethylene terephthalate (PET), polyethylene naphthalate (PEN), polycarbonate (PC), polypropylene (PP), polyimide (PI), triacetate cellulose (TAC), and combinations thereof; and the conductive film comprises a compound selected from the group consisting of indium tin oxide (ITO), fluorine tin oxide (FTO), ZnO-Ga₂O₃, ZnO-Al₂O₃, SnO₂-Sb₂O₃ and combinations thereof.

18. The dye-sensitized solar cell of claim 1, wherein the second electrode comprises a transparent substrate and a first conductive film which is coated on the transparent substrate and a second conductive film which is coated on the first conductive film; the transparent substrate comprises a compound selected from the group consisting of polyethylene terephthalate (PET), polyethylene naphthalate (PEN), polycarbonate (PC), polypropylene (PP), polyimide (PI), triacetate cellulose (TAC), and combinations thereof; the first conductive film of the second electrode comprises a compound selected from the group consisting of indium tin oxide (ITO), fluorine tin oxide (FTO), ZnO-Ga₂O₃, ZnO-Al₂O₃, SnO₂-Sb₂O₃, and combinations thereof; and the second conductive film comprises a compound selected from the group consisting of platinum, carbon nanotube (CNT), and noble metals.
